# EUROPÄISCHE PATENTSCHRIFT

(11) **EP 3 994 737 B1**
(45) Veröffentlichungstag und Bekanntmachung des Hinweises auf die Patenterteilung: **15.05.2024**
(21) Anmeldenummer: 20757213.2
(22) Anmeldetag: 03.07.2020
(51) Int. Cl.: H02N 2/02, H10N 30/20

(54) **ULTRASCHALLAKTUATOR UND MOTOR MIT EINEM SOLCHEN ULTRASCHALLAKTUATOR**
AN ULTRASONIC ACTUATOR AND A MOTOR HAVING SUCH AN ULTRASONIC ACTUATOR
ACTIONNEUR À ULTRASONS ET MOTEUR COMPRENANT UN TEL ACTIONNEUR À ULTRASONS

(30) Priorität: 05.07.2019 DE 102019118198
(43) Veröffentlichungstag der Anmeldung: 11.05.2022
(73) Patentinhaber: Physik Instrumente (PI) GmbH & Co. KG, 76228 Karlsruhe (DE)
(72) Erfinder: HÜBNER, Reinhard, 76337 Waldbronn (DE)
(74) Vertreter: Grünecker Patent- und Rechtsanwälte PartG mbB
(86) Internationale Anmeldenummer: PCT/DE2020/100586
(87) Internationale Veröffentlichungsnummer: WO 2021/004583

(56) Entgegenhaltungen:
- EP-B1- 2 153 476
- US-A1- 2012 228 994
- US-A1- 2016 049 578
- MANABU AOYAGI ET AL: "ULTRASONIC MOTORS USING LONGITUDINAL AND BENDING MULTIMODE VIBRATORS WITH MODE COUPLING BY EXTERNALLY ADDITIONAL ASYMMETRY OR INTERNAL NONLINEARITY", JAPANESE JOURNAL OF APPLIED PHYSICS, JAPAN SOCIETY OF APPLIED PHYSICS, JP, Bd. 31, Nr. 9B, 1. September 1992 (1992-09-01), Seiten 3077-3080, XP000355713, ISSN: 0021-4922, DOI: 10.1143/JJAP.31.3077

## Beschreibung

Die Erfindung betrifft einen Ultraschallaktuator in Form einer Platte mit einer Grundfläche, einer zu der Grundfläche geometrisch ähnlichen Deckfläche und einer die Grundfläche und die Deckfläche miteinander verbindenden Seitenfläche, wobei die Platte ein elektromechanisches Material aufweist und an deren Grundfläche und an deren der Grundfläche gegenüberliegenden Deckfläche Elektroden zur Anregung periodischer Deformationen der Platte angeordnet sind, und die Grundfläche wenigstens zwei parallel zueinander angeordnete Seiten aufweist, welche Kontaktabschnitte der Seitenfläche definieren, und die zwei parallel zueinander angeordneten Seiten der Grundfläche zusammen mit Verbindungslinien, welche die jeweiligen Endpunkte der parallel zueinander angeordneten Seiten miteinander verbinden, ein in die Grundfläche einbeschriebenes Parallelogramm bilden, gemäß Oberbegriff des Anspruchs 1. Die Erfindung betrifft zudem einen Motor mit einem solchen Ultraschallaktuator, der einen Ultraschallmotor bildet.

Unter dem vorstehend und auch im Nachfolgenden verwendeten Begriff ,elektromechanisches Material` ist dabei ein Material zu verstehen, welches bei Anlegen einer elektrischen Spannung und entsprechender Ausbildung eines elektrischen Feldes eine mechanische Deformation vollführt. Insbesondere fallen darunter Materialien mit piezoelektrischen Eigenschaften, etwa piezokeramische Materialien, aber beispielsweise auch elektrostriktive Eigenschaften aufweisende Materialien.

Derartige Ultraschallaktuatoren bzw. die diese umfassenden Ultraschallmotoren können in miniaturisierten, preiswerten Geräten mit geringem Energieverbrauch, wie beispielsweise in Miniaturfotoapparaten, Objektiven von Handys bzw. Smartphones, Miniaturspeichereinrichtungen und ähnlichen Geräten verwendet werden, wo kleine Abmessungen, hohe Positioniergenauigkeit und ein niedriger Energieverbrauch durch den Antrieb erforderlich sind.

Aus den Druckschriften US 5 672 930 und US 5 665 918 sind Ultraschallaktuatoren für Ultraschallmotoren bekannt, die als komplexe zusammengesetzte Vibratoren konzipiert sind und aus einem Resonanzkörper, auf dem piezoelektrische Erregerplatten aufgeklebt sind, bestehen. Der Nachteil dieser Aktuatoren liegt darin, dass sie einen relativ komplizierten Aufbau aufweisen und ihre Herstellung aufwendig ist. Daher scheiden sie als preiswertes Massenprodukt für den Einsatz in miniaturisierten Geräten aus.

Aus der Druckschrift US 6 765 335 B2 ist ferner ein Ultraschallaktuator für einen Ultraschallmotor bekannt, bei dem der Resonanzkörper als piezoelektrische Platte mit einer rechteckigen Form ausgebildet ist. Dieser Ultraschallaktuator zeichnet sich zwar durch eine einfache Konstruktion und eine leicht beherrschbare Herstellungstechnologie aus, weshalb er als preiswertes Massenprodukt geeignet erscheint. Jedoch besteht bei diesem Ultraschallaktuator der Nachteil, dass für dessen Betrieb eine relativ hohe elektrische Leistung erforderlich ist, wodurch ein erhöhter Energieverbrauch resultiert. Daher scheidet ein solcher Ultraschallaktuator für die Verwendung in Miniaturvorrichtungen mit entsprechend erforderlichem geringen Energieverbrauch ebenfalls aus.

Der aus der EP 2 153 476 B1 bekannte Ultraschallaktuator kann die zuvor beschriebenen Probleme zwar lösen, indem dieser Ultraschallaktuator eine vergleichsweise einfache Konstruktion aufweist und zugleich einen geringen elektrischen Energieverbrauch bei hoher Betriebsstabilität bzw. Sicherheit besitzt. Dennoch ist mit dem in der EP 2 153 476 B1 offenbarten Ultraschallaktuator eine Realisierung eines entsprechenden Ultraschallmotors mit höherem Aufwand verbunden, insbesondere im Hinblick auf die Struktur des Läufers eines solchen Motors. Hierbei gestaltet es sich als vergleichsweise aufwändig, die für einen dauerhaft verlässlichen Betrieb notwendige konstante Anpresskraft des Läufers an den Ultraschallaktuator über den gesamten Verfahrweg des Läufers zu realisieren.

Die Aufgabe der Erfindung besteht deshalb darin, einen Ultraschallaktuator bereitzustellen, der neben einer einfachen Konstruktion und einem geringen elektrischen Energieverbrauch auch die Eigenschaft besitzt, mit diesem einen einfach aufgebauten und dennoch dauerhaft zuverlässigen Motor realisieren zu können, der sich leicht und insbesondere in hohen Stückzahlen fertigen und montieren lässt und der eine gute Skalierbarkeit bzw. Miniaturisierbarkeit aufweist.

Diese Aufgabe wird gelöst durch einen Ultraschallaktuator gemäß Anspruch 1. Bei dem erfindungsgemäßen Ultraschallaktuator ist bezüglich des in die Grundfläche eingeschriebenen Parallelogramms jeweils zwischen aneinanderstoßenden bzw. angrenzenden oder benachbarten Seiten ein von 90° abweichender Winkel eingeschlossen. Mit anderen Worten handelt es sich bei dem eingeschriebenen Parallelogramm gerade nicht um ein rechtwinkliges Parallelogramm.

Durch die spezifische Form des eingeschriebenen Parallelogramms sind die jeweils parallel zueinander angeordneten Seiten durch Verschieben entlang ihrer jeweiligen Seitennormalen nicht in vollständige Überdeckung zu bringen, wie das bei einem rechtwinkligen Parallelogramm der Fall wäre. Mit anderen Worten treffen sich die Normalen, die jeweils durch den Mittelpunkt der entsprechenden Seite verlaufen, nicht, sondern sind parallel und versetzt zueinander angeordnet. Wirken nun Kräfte entlang der Normalen bezüglich der durch die entsprechenden Seiten der Seitenfläche gebildeten Kontaktabschnitte bzw. Kontaktflächen - beispielsweise aufgrund eines Anpressens von Laufflächen eines gegenüber dem Ultraschallaktuator zu bewegenden Läufers gegen die Kontaktabschnitte bzw. Kontaktflächen des Ultraschallaktuators -, so resultiert ein Drehmoment, welches den Ultraschallaktuator zu drehen versucht. Das entsprechende und auf die Laufflächen wirkende Gegendrehmoment kann dazu genutzt werden, eine definierte Anpresskraft eines mit dem Läufer verbundenen oder integral mit diesem ausgeführten Führungsteils bzw. dessen Führungsabschnitten gegen Führungselemente einer Führungsvorrichtung zu erzeugen. Auf diese Weise kann über die Laufflächen, die beispielsweise integraler Bestandteil des Läufers sind, gleichzeitig die für einen optimierten Betrieb des entsprechenden Ultraschallmotors notwendige mechanische Vorspannung auf den Ultraschallaktuator und die vorstehend beschriebene Anpresskraft von Führungsabschnitten gegen Führungselemente einer Führungsvorrichtung, und vorzugsweise einer Gleitführung, realisiert werden.

Hierbei kann es von Vorteil sein, dass die größeren Innenwinkel des eingeschriebenen Parallelogramms Werte zwischen 93° und 105° und bevorzugt zwischen 95° und 99° aufweisen. Dementsprechend haben die kleineren Innenwinkel des eingeschriebenen Parallelogramms Werte zwischen 87° und 75° und bevorzugt Werte zwischen 85° und 81 °. Bei einer derartigen Geometrie des eingeschriebenen Parallelogramms ist bei einem entsprechenden Ultraschallmotor, bei dem Laufflächen eines Läufers gegen die Kontaktabschnitte des Ultraschallaktuators gedrückt sind, ein für einen dauerhaften und verlässlichen Betrieb des Ultraschallmotors vorteilhaftes Gegendrehmoment auf eine mit dem Läufer verbundene Führungsvorrichtung aufbringbar, während bei kleineren Werten für die größeren Innenwinkel kein hierfür ausreichendes Drehmoment bzw. Gegendrehmoment mehr erzielbar ist. Bei größeren Werten des größeren Innenwinkels ergibt sich eine weniger stabile sowie weniger definierte Schwingung des Ultraschallaktuators, die bei einem entsprechenden Ultraschallmotor zu einer geringeren Positioniergenauigkeit und zu einem ungleichmäßigeren Antrieb führt.

Erfindungsgemäß ist die Grundfläche bzw. die dazu parallel angeordnete und geometrisch ähnliche und bevorzugt identisch geformte Deckfläche achteckig und beidseits des eingeschriebenen Parallelogramms schließt sich jeweils ein Trapez und bevorzugt ein gleichschenkliges Trapez an, und die Basis jedes Trapezes fällt mit der jeweiligen längeren Seite des eingeschriebenen Parallelogramms zusammen. Bei der daraus resultierenden prismatischen Form des Ultraschallaktuators ist bei vergleichsweise geringem Materialaufwand eine besonders effektive Anregung von zum Antrieb eines Läufers nutzbaren Deformationen ermöglicht.

Im Falle eines gleichschenkligen Trapezes kann es von Vorteil sein, dass die Länge einer Diagonale eines Trapezes im Wesentlichen identisch ist zu dem Abstand zwischen der der Basis dieses Trapezes gegenüberliegenden Seite bzw. Grundseite und der Basis des anderen Trapezes. Bei diesen geometrischen Verhältnissen resultiert ein Ultraschallaktuator, dessen Breite kleiner ist als das Doppelte seiner Höhe und der dadurch einen vergleichsweise geringen Platzbedarf bei gleichzeitig reduziertem Materialaufwand hat. Zudem führen solche geometrischen Verhältnisse des Ultraschallaktuators dazu, dass sich drei Dimensionen zur genutzten Schwingungsmode überlagern. Dabei kann eine Dimension der Schwingungsmode durch äußere Einflüsse unterdrückt werden, ohne dass die genutzte Schwingungsmode verschwindet. Das macht den Motor insgesamt robuster gegen äußere Einflüsse und die mechanische Umgebung des Aktors.

Die Erfindung betrifft ferner einen Motor mit einem vorstehend beschriebenen Ultraschallaktuator umfassend eine Halterungsvorrichtung zur ortsfesten Halterung des Ultraschallaktuators und einen relativ zu dem Ultraschallaktuator beweglichen und sich mit diesem in direktem oder indirektem Friktionskontakt befindenden Läufer, wobei die Halterungsvorrichtung wenigstens vier Halteabschnitte aufweist, die den Ultraschallaktuator an unterschiedlichen Bereichen kontaktieren, wovon zwei Halteabschnitte mechanisch steif ausgeführt sind und steife Halteabschnitte bilden, und wovon zwei Halteabschnitte federnde Eigenschaften aufweisen und federnde Halteabschnitte bilden.

Hierbei kann es von Vorteil sein, dass die steifen Halteabschnitte und die federnden Halteabschnitte jeweils schräg gegenüberliegend zueinander angeordnet sind.

Zudem kann es von Vorteil sein, dass die Halterungsvorrichtung zwei weitere Halteabschnitte aufweist, die jeweils einen Bereich der Seitenfläche des Ultraschallaktuators kontaktieren, der zwischen dem von dem jeweiligen steifen Halteabschnitt und dem jeweiligen federnden Halteabschnitt kontaktierten Bereich der Seitenfläche gelegen ist.

In einer Ausführungsform kann der Motor so ausgestaltet sein, dass der Läufer zwei langgestreckte und parallel zueinander angeordnete Laufflächen umfasst, die den Ultraschallaktuator an den Kontaktabschnitten direkt oder indirekt kontaktieren und diesen zwischen sich einspannen. Durch die über die Kontaktabschnitte eingeleiteten Einspannkräfte wirkt aufgrund seiner spezifischen geometrischen Form ein Drehmoment auf den Ultraschallaktuator, durch welches dieser mit dem jeweiligen Abschnitt der Seitenfläche gegen den jeweiligen steifen Halteabschnitt des Halterungselements gedrückt ist.

Es kann hierbei vorteilhaft sein, dass der Läufer ein Führungsteil mit wenigstens zwei voneinander beabstandeten Führungsabschnitten umfasst, wobei sich die Führungsabschnitte mit Führungselementen oder Führungsabschnitten in eine Gleitbewegung ermöglichendem Eingriff befinden. Im Falle von Führungselementen liegen diese separat vor, während im Falle von Führungsabschnitten diese in bevorzugter Weise integraler Bestandteil der Halterungsvorrichtung sind. Die Führungsabschnitte sind bevorzugt integral mit dem Führungsteil ausgebildet, und das Führungsteil ist bevorzugt integral mit dem Läufer ausgebildet.

Es folgt die Beschreibung einer Ausführungsform des erfindungsgemäßen Ultraschallaktuators und eines entsprechenden Motors mit Hinblick auf die entsprechenden Figuren, wobei sich gleiche Bezugszeichen auf gleiche Teile der unterschiedlichen Figuren beziehen.
Fig. 1: Draufsicht auf die Grundfläche eines erfindungsgemäßen Ultraschallaktuators
Figs. 2A, 2B: Unterschiedliche perspektivische Darstellungen des Ultraschallaktuators gemäß Fig. 1
Fig. 3: Perspektivische Darstellung einer Ausführungsform eines Motors mit einem Ultraschallaktuator gemäß den Figs. 1 und 2
Fig. 4: Halterungsvorrichtung für einen Ultraschallaktuator des Motors gemäß Fig. 3
Fig. 5: Seitenansicht des Motors gemäß Fig. 3
Fig. 6: Perspektivische Darstellung einer Ausführungsform eines Motors mit dem Ultraschallaktuator gemäß den Figs. 1 und 2

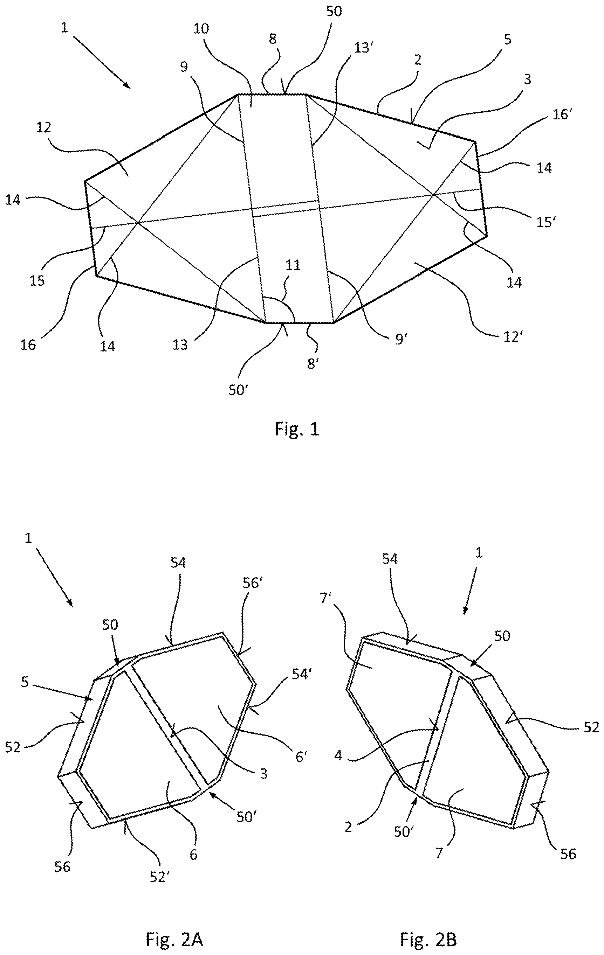

Figur 1 zeigt in einer Draufsicht die Grundfläche 3 eines erfindungsgemäßen Ultraschallaktuators 1, welcher die Form einer achteckigen Platte 2 bzw. eines achteckigen Prismas aufweist, so dass die der Grundfläche 3 gegenüberliegende und in Fig. 1 nicht zu erkennende Deckfläche eine zu der Grundfläche 3 identische Form aufweist, und die die Grundfläche 3 und die Deckfläche miteinander verbindende Seitenfläche 5 sowohl senkrecht zu der Grundfläche 3, als auch senkrecht zu der Deckfläche angeordnet ist. Denkbar sind jedoch auch Ausführungsformen des Ultraschallaktuators 1, bei dem sich die Form der Grundfläche 3 und der Deckfläche bei geometrischer Ähnlichkeit voneinander unterscheiden, so dass die Seitenfläche 5 nicht senkrecht zu der Grundfläche 3 bzw. zu der Deckfläche angeordnet ist.

Aufgrund der achteckigen Form der Grundfläche 3 und der entsprechenden Prismenform des Ultraschallaktuators resultiert eine Seitenfläche 5 mit acht voneinander unterscheidbaren Abschnitten, wobei die Seiten 8 und 8' Kontaktabschnitte 50 und 50' der Seitenfläche 5 bilden. Die Kontaktabschnitte 50 und 50' sind für einen direkten oder indirekten Kontakt mit einem durch den Ultraschallaktuator anzutreibenden Element eines entsprechenden Ultraschallmotors vorgesehen.

Zwei der kürzeren Seiten der Grundfläche 3, nämlich die Seiten 8 und 8', sind parallel und beabstandet zueinander angeordnet, wobei sich durch eine Verschiebung der Seiten entlang ihrer jeweiligen Seitennormale die Seiten 8 und 8' nicht in vollständige Überdeckung bringen lassen. Mit anderen Worten sind die Seiten 8 und 8' in ihrer Erstreckungsrichtung gesehen versetzt zueinander angeordnet. In entsprechender Weise resultiert mit zwei Verbindungslinien 9 und 9', welche die jeweils korrespondierenden Endpunkte der Seiten 8 und 8' miteinander verbinden, ein in die Grundfläche 3 eingeschriebenes Parallelogramm 10, das nicht rechtwinklig ist bzw. bei dem aneinandergrenzende oder aneinanderstoßende Seiten einen von 90° abweichenden Winkel zwischen sich einschließen. Die beiden größeren Winkel 11 des Parallelogramms betragen hierbei 97°, so dass sich kleinere Winkel des Parallelogramms von 83° ergeben.

Zu beiden Seiten des eingeschriebenen Parallelogramms 10 schließt sich hinsichtlich der Grundfläche 3 jeweils ein gleichschenkliges Trapez 12, 12' an, dessen jeweilige Basis 13, 13' mit der jeweiligen längeren Seite des eingeschriebenen Parallelogramms 10, welche der jeweiligen Verbindungslinie 9, 9' entspricht, zusammenfällt. Die Länge jeder Diagonale 14 eines Trapezes 12, 12' ist im Wesentlichen identisch zu dem kürzesten Abstand 15 zwischen der der Basis 13, 13' dieses Trapezes gegenüberliegenden Seite 16, 16' und der Basis 13, 13' des jeweils anderen Trapezes 12, 12'. Im vorliegenden Fall sind die Seiten 16, 16', welche ebenfalls kürzere Seiten der Form der Grundfläche 3 darstellen, parallel zu der Basis 13, 13' des jeweiligen Trapezes 12, 12' angeordnet.

Aufgrund des Abweichens des eingeschriebenen Parallelogramms 10 von einem rechtwinkligen Parallelogramm treffen sich die vom Mittelpunkt der der Basis 13, 13' gegenüberliegenden und dazu parallel verlaufenden Seite 16, 16' des jeweiligen rechtwinkligen Trapezes ausgehenden Seitennormalen nicht, sondern verlaufen parallel und beabstandet zueinander.

Fig. 2A zeigt den Ultraschallaktuator 1 gemäß Fig. 1 in einer perspektivischen Darstellung mit Blick hauptsächlich auf die Grundfläche 3. An der achteckigen Grundfläche 3 sind zwei identisch ausgebildete und spiegelbildlich zueinander angeordnete Elektroden 6 und 6' gelegen, die durch einen zwischenliegenden Spalt voneinander getrennt und dadurch elektrisch isoliert voneinander sind. Neben den durch die Seiten 8 und 8' der Grundfläche 3 gebildeten Kontaktabschnitten 50 und 50' bilden die längeren Seiten der Grundfläche 3 die Abschnitte 52, 52', 54 und 54' der Seitenfläche 5, während die beiden verbleibenden kürzeren Seiten 16 und 16' der Grundfläche 3 die Abschnitte 56 und 56' der Seitenfläche 5 bilden bzw. definieren.

Fig. 2B zeigt den Ultraschallaktuator von Fig. 1 in anderer perspektivischer Darstellung, so dass hier hauptsächlich die Deckfläche 4 zu sehen ist. Ebenso wie an der Grundfläche 3 sind an der Deckfläche 4 zwei identisch geformte und spiegelbildlich zueinander angeordnete Elektroden 7 und 7' gelegen, die ebenfalls durch einen zwischenliegenden Trennspalt voneinander beabstandet und dadurch elektrisch isoliert voneinander sind. Die beiden Elektroden 7 und 7' der Deckfläche sind spiegelbildlich zu den beiden auf der Grundfläche 3 angebrachten Elektroden 6 und 6' angeordnet. Es ist denkbar, an der Grundfläche 3 und der Deckfläche 4 jeweils mehr als zwei Elektroden anzuordnen. Zudem ist es denkbar, dass sich die Zahl der Elektroden an der Grundfläche von der Zahl der Elektroden an der Deckfläche unterscheidet; so können etwa an der Grundfläche zwei Elektroden angeordnet sein, während an der Deckfläche nur eine Elektrode angeordnet ist.

Die Kontaktabschnitte 50 und 50' stellen entsprechende Oberflächen des Ultraschallaktuators 1 dar und können direkt in Kontakt mit einem relativ zu dem Ultraschallaktuator 1 zu bewegenden bzw. zu verstellenden Element, beispielsweise einem Läufer, stehen. Da es bei direktem Kontakt jedoch zu erhöhtem Verschleiß des normalerweise eher schlechte tribologische Eigenschaften aufweisenden elektromechanischen Materials des Ultraschallaktuators 1 kommen kann, ist vorzugsweise vorgesehen, an den Kontaktabschnitten 50 und 50' Friktionselemente anzuordnen, die hinsichtlich Reibungs- und Verschleißeigenschaften optimiert sind. Bei dem Vorhandensein von an den Kontaktabschnitten 50 und 50' angeordneten Friktionselementen resultiert ein dann indirekter Kontakt zwischen den Kontaktabschnitten 50 und 50' des Ultraschallaktuators und einem relativ zu dem Ultraschallaktuator 1 zu bewegenden bzw. zu verstellenden Element.

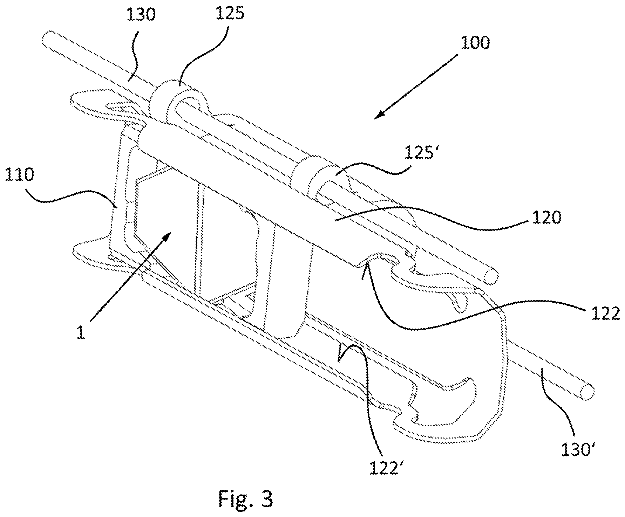

Figur 3 zeigt in einer perspektivischen Darstellung eine mögliche Ausführungsform für einen als Linearantrieb realisierten Motor 100 mit einem Ultraschallaktuator 1 nach den Figuren 1 und 2. Hierbei ist der Ultraschallaktuator in eine Halterungsvorrichtung 110 eingesetzt, welche in einer in Fig. 3 nicht erkennbaren Weise selbst mit einem übergeordneten ortsfesten Element, beispielsweise einer Basis, verbunden ist, so dass insgesamt eine ortsfeste Halterung des Ultraschallaktuators resultiert.

Gegenüber bzw. relativ zu dem Ultraschallaktuator beweglich ist ein Läufer 120 in Form eines räumlich strukturierten Blechs mit zwei integral mit diesem ausgebildeten langgestreckten und parallel zueinander angeordneten Laufflächen 122, 122', die über in Fig. 3 nicht erkennbare Friktionselemente indirekt mit den Kontaktabschnitten 50, 50' des Ultraschallaktuators in Kontakt stehen.

Die spezielle Ausgestaltung des Läufers 120 verleiht diesem u.a. spezifische federnde Eigenschaften, mit welcher die Laufflächen 122, 122' - nach Einsetzen der Halterungsvorrichtung 110 in den Läufer 120 - mit einer definierten Kraft gegen die Friktionselemente bzw. die Kontaktabschnitte 50, 50' gedrückt bzw. gepresst sind. Diese Kraft sorgt zum Einen dafür, dass der Ultraschallaktuator mit einer für einen verlässlichen und definierten Betrieb notwendigen Vorspannung beaufschlagt ist, und zum Anderen - aufgrund der erfindungsgemäßen Geometrie des Ultraschallaktuators - für eine Beaufschlagung des Ultraschallaktuators mit einem Drehmoment in einer dem Uhrzeigersinn entgegengesetzten Richtung, welches diesen fest gegen die Halterungsvorrichtung 110 drückt, so dass der Ultraschallaktuator fest in dieser gehaltert ist.

Das so auf den Ultraschallaktuator einwirkende Drehmoment ruft ein in Uhrzeigersinn gerichtetes Gegendrehmoment hervor, welches auf den Läufer 120 wirkt. Mit dem Läufer 120 integral ausgeführt sind zwei voneinander beabstandete und unterschiedlich geformte Führungsabschnitte 125 und 125' und zwei dazu jeweils gegenüberliegend angeordnete und in Fig. 3 nicht zu erkennende Lagerungsabschnitte 126 und 126' aufweist. Es ist ebenso denkbar, die Führungsabschnitte 125, 125' und/oder die Lagerungsabschnitte 126, 126' separat auszuführen und mit dem Läufer 120 zu verbinden, beispielsweise durch eine Schraub- oder Klebeverbindung.

Die Führungsabschnitte 125, 125' befinden sich in gleitendem Eingriff mit zwei parallel zueinander angeordneten, rundstabförmigen Führungselementen 130, 130' aus Stahl. Es ist ebenso denkbar, Führungselemente 130, 130' aus einer Keramik zu verwenden. Der Führungsteil 124 mit seinen Führungsabschnitten bildet zusammen mit den Führungselementen 130, 130' eine Gleitführung, welche dazu dient, die bereits durch die Form der Laufflächen 122, 122' und deren Kontaktsituation mit den Friktionselementen des Ultraschallaktuators provozierte lineare Bewegung des Läufers 120 zu präzisieren.

Das auf den Läufer 120 einwirkende Gegendrehmoment sorgt dafür, dass die Führungsabschnitte 125 und 125' definiert an dem in Fig. 3 oberen Führungselement 130 anliegen. Die Führungsabschnitte 125 und 125' weisen jeweils einen Durchbruch auf, durch den das Führungselement 130 hindurchragt. Der Querschnitt der Führungsabschnitte 125, 125' ist nicht rund, sondern weist jeweils einen V-förmigen Bereich auf, dessen beide Flanken zur Abstützung des Führungselements 130 dienen. Während bei dem in Fig. 3 linken Führungsabschnitt 125 der V-förmige Abschnitt nach unten weist, weist er bei dem in Fig. 3 rechten Führungsabschnitte 125' nach oben. Das auf den Läufer 120 einwirkende Gegendrehmoment bewirkt nun, dass die V-förmigen Bereiche der Führungsabschnitte 125, 125' bzw. deren Flanken mit einer definierten Kraft an dem Führungselement 130 anliegen und somit gleichzeitig eine definierte gegenseitige Ausrichtung zwischen dem Führungselement 130 und den Führungsabschnitten 125, 125' stattfindet.

Die Kraft, mit welcher die Flanken bzw. Schenkel der V-förmigen Bereiche der Führungsabschnitte 125, 125' gegen das Führungselement 130 gedrückt sind, lässt sich beeinflussen durch die über die Laufflächen 122, 122' des Läufers 120 auf den Ultraschallaktuator 1 einwirkenden Kräfte, welche in erster Linie von den federnden Eigenschaften des Blechs des Läufers 120 und dessen Geometrien und den Geometrien des Ultraschallaktuators abhängen. Je höher diese Kräfte und das daraus resultierende und auf den Ultraschallaktuator wirkende Drehmoment sind, desto größer ist das entsprechende und auf den Läufer wirkende Gegendrehmoment. Je weiter nun die Führungsabschnitte 125, 125' voneinander beabstandet sind, umso geringer sind aufgrund der wachsenden Hebellängen die Anpresskräfte der Flanken bzw. Schenkel der V-förmigen Bereiche der Führungsabschnitte 125, 125' gegen das Führungselement 130. Somit lässt sich auch durch den Abstand der Führungsabschnitte 125, 125' eine Anpassung dieser Anpresskräfte erzielen.

Die so gebildete Gleitlagerung bzw. Gleitführung ist montagefreundlich, vergleichsweise einfach realisierbar und damit insgesamt kostengünstig. Die Anpresskräfte lassen sich gezielt anpassen, so dass insbesondere geringe Reibwiderstände entstehen, gegen die der Ultraschallaktuator arbeiten muss. Gleichzeitig ist eine solche Gleitführung mechanisch hochbelastbar und weist eine hohe Ablaufgenauigkeit auf.

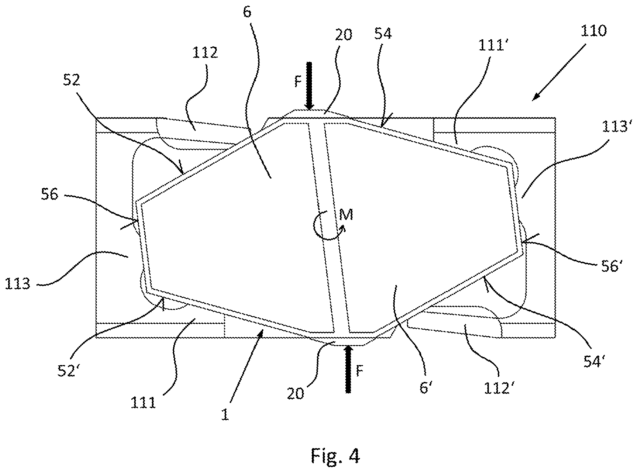

Fig. 4 zeigt in separierter Weise und damit als Detail des Motors nach Fig. 3 nur die Halterungsvorrichtung 110 mit dem darin eingesetzten Ultraschallaktuator 1 gemäß den Figuren 1 und 2. Die Halterungsvorrichtung 110, welche aus Polyetheretherketon (PEEK) besteht, weist insgesamt sechs Halteabschnitte 111, 111', 112, 112', 113, 113' auf, die den Ultraschallaktuator an unterschiedlichen Abschnitten 52, 52', 54, 54', 56, 56' seiner Seitenfläche 5 kontaktieren und den Ultraschallaktuator damit fest einspannen bzw. halten. Andere, insbesondere polymere Materialien, für die Halterungsvorrichtung 110 sind ebenso denkbar, etwa Polyoxymethylen (POM) oder Polyamid (PA).

Zwei der Halteabschnitte, welche den Ultraschallaktuator an seinen längeren Seitenflächenabschnitten 52', 54 kontaktieren, sind mechanisch wenig nachgiebig und damit steif ausgeführt und bilden entsprechend steife Halteabschnitte 111, 111', während die zwei anderen Halteabschnitte, welche den Ultraschallaktuator ebenso an längeren, aber anderen Seitenflächenabschnitten 52, 54' kontaktieren, mechanisch nachgiebig sind, damit federnde Eigenschaften aufweisen und entsprechend federnde Kontaktabschnitte 112, 112' bilden. Die Halteabschnitte 113, 113' kontaktieren den Ultraschallaktuator an den kürzeren Seitenflächenabschnitten 56, 56' und sind ebenfalls mechanisch wenig nachgiebig ausgeführt.

Die von den Laufflächen 122, 122' des Läufers 120 auf die beiden Friktionselemente 20 einwirkenden Kräfte F sind in Fig. 4 ebenso gekennzeichnet wie das daraus auf den Ultraschallaktuator 1 einwirkende Drehmoment M, welches den Ultraschallaktuator entgegen dem Uhrzeigersinn zu drehen versucht. Aufgrund dieses Drehmoments M werden die Seitenflächenabschnitte 52' und 54 stärker gegen die steifen Kontaktabschnitte 111 und 111' gedrückt, wogegen diese sich damit fester abstützen. Gleichzeitig versuchen die Seitenflächenabschnitte 52 und 54' sich durch das einwirkende Drehmoment M von den federnden Kontaktabschnitten 112, 112' weg zu bewegen, wobei deren federnde Eigenschaften jedoch für gleichbleibenden Kontakt mit diesen Seitenflächenabschnitten 52 und 54' sorgen, so dass die Anpresskraft der federnden Kontaktabschnitte 112, 112' gegen die Seitenflächenabschnitte 52 und 54' unabhängig von dem einwirkenden Drehmoment M ist.

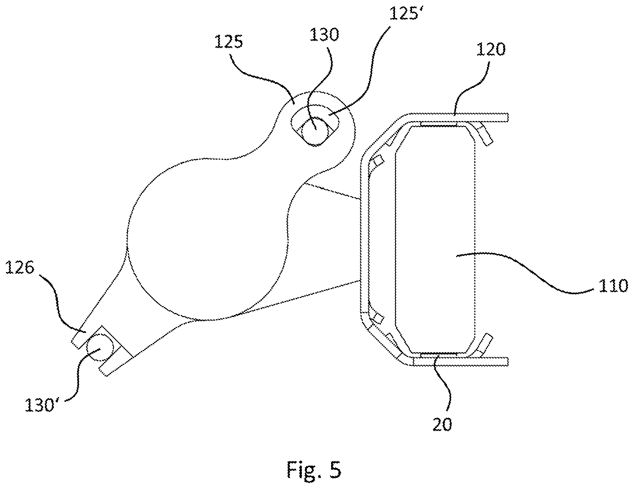

Fig. 5 zeigt den Motor gemäß Fig. 3 in einer Seitenansicht, wobei die Blickrichtung mit der Antriebsrichtung zusammenfällt. Hierbei ist insbesondere die Querschnittsform der Führungsabschnitte 125, 125' und des Lagerungsabschnitts 126 und deren Eingriffssituation mit den Führungselementen 130, 130' zu erkennen. Der in Fig. 5 nach vorne weisende Führungsabschnitt 125 hat einen nach unten weisenden V-förmigen Abschnitt, und das Führungselement 130 liegt an beiden Flanken bzw. Schenkeln des V-förmigen Abschnitts an bzw. stützt sich daran ab. Der in Fig. 5 nach hinten weisende Führungsabschnitt 125', von dem nur ein Teil zu erkennen ist, hat einen nach oben weisenden V-förmigen Abschnitt, und das Führungselement 130 liegt auch hier an beiden Flanken bzw. Schenkeln dieses V-förmigen Abschnitts an. Das auf den Läufer einwirkende Gegendrehmoment - resultierend aus dem über den Läufer auf den Ultraschallaktuator einwirkenden Drehmoment - dient also zum Andrücken und gleichzeitigen Ausrichten des Führungselements 130 in den Führungsabschnitten 125, 125'. Den Führungsabschnitten 125 und 125' gegenüberliegend ist ein jeweiliger Lagerungsabschnitt 126, 126' angeordnet, von welchen jedoch nur der nach vorne weisende Lagerungsabschnitt 126 zu erkennen ist. Dieser weist eine rechtwinklige, nutförmige Ausnehmung auf, in welcher das Führungselement 130' spielbehaftet gelagert ist. Der Lagerungsabschnitt 126' weist eine zu dem Lagerungsabschnitt 126 identische Querschnittsgeometrie auf. Die Lagerungsabschnitte 126 und 126' dienen dazu, eine Rotation des Lagerteils 124 des damit fest verbundenen Läufers 120 um das Führungselement 130 zu vermeiden

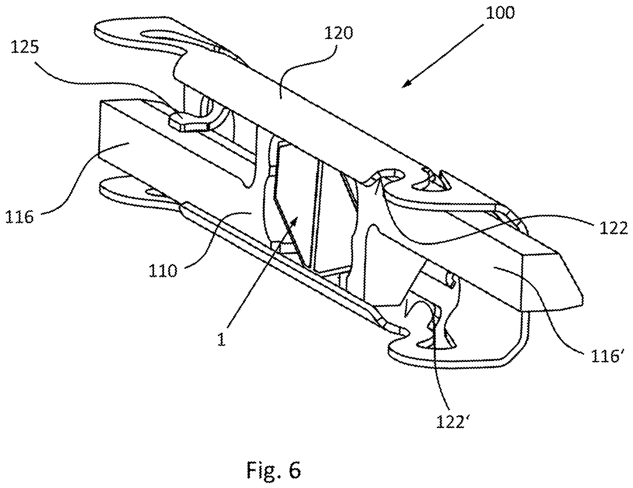

Fig. 6 zeigt in einer perspektivischen Darstellung eine weitere mögliche Ausführungsform für einen als Linearantrieb realisierten Motor 100 mit einem Ultraschallaktuator 1 nach den Figuren 1 und 2. Hierbei umfasst die identisch zu Fig. 3 bzw. 4 ausgebildete Halterungsvorrichtung 110 integral mit dieser ausgebildete, langgestreckte Führungsabschnitte 116, 116', gegen die sich integral mit dem Läufer 120 in Form eines räumlich strukturierten Blechs ausgebildete Führungsabschnitte 125, 125' in Form eines gebogenen bzw. abgewinkelten Stegs abstützen, von denen in Fig. 6 nur der Führungsabschnitt 125 zu erkennen ist. Durch die Übernahme der Funktion der Führungselemente 130 in den Figuren 3 und 5 durch integral mit der Halterungsvorrichtung 110 ausgebildeten Führungsabschnitten 116, 116' ist eine deutlich kompaktere und weniger Bauteile aufweisende Ausführung eines Motors mit dem erfindungsgemäßen Ultraschallaktuator möglich, der zudem leichter und schneller zusammenbaubar ist.

### Bezugszeichenliste:

- 1:: Ultraschallaktuator
- 2:: Platte
- 3:: Grundfläche (der Platte 2)
- 4:: Deckfläche (der Platte 2)
- 5:: Seitenfläche (der Platte 2)
- 6,6':: Elektroden
- 7, 7':: Elektroden
- 8, 8':: Seiten (der Grundfläche 3)
- 9, 9`:: Verbindungslinien
- 10:: Parallelogramm (eingeschrieben in die Grundfläche 3)
- 11:: größere Innenwinkel (des eingeschriebenen Parallelogramms 10)
- 12, 12':: Trapez (der Grundfläche 3)
- 13, 13':: Basis (des Trapezes 12, 12')
- 14:: Diagonale (des Trapezes 12, 12')
- 15:: Abstand (zwischen der der Basis 13, 13' eines Trapezes 12, 12' gegenüberliegenden Seite 16, 16' und der Basis des jeweils anderen Trapezes)
- 16, 16': Seite (der Basis 13, 13' des Trapezes 12, 12' gegenüberliegend)
- 20:: Friktionselement
- 50:: Kontaktabschnitte (der Seitenfläche 5)
- 52, 52':: Abschnitte (der Seitenfläche 5)
- 54, 54':: Abschnitte (der Seitenfläche 5)
- 56, 56':: Abschnitte (der Seitenfläche 5)
- 100:: Motor
- 110:: Halterungsvorrichtung (des Motors 100)
- 111, 111':: steife Halteabschnitte (der Halterungsvorrichtung 110)
- 112, 112':: federnde Halteabschnitte (der Halterungsvorrichtung 110)
- 113, 113':: Halteabschnitte (der Halterungsvorrichtung 110)
- 116, 116`:: Führungsabschnitte (der Halterungsvorrichtung 110)
- 120:: Läufer
- 122, 122':: Laufflächen (des Läufers 120)
- 125, 125`:: Führungsabschnitte (des Läufers 120)
- 126, 126':: Lagerungsabschnitte (des Läufers 120)
- 130, 130`:: Führungselemente

## Patentansprüche

1. Ultraschallaktuator (1) in Form einer Platte (2) mit einer Grundfläche (3), einer zu der Grundfläche geometrisch ähnlichen Deckfläche (4) und einer die Grundfläche und die Deckfläche miteinander verbindenden Seitenfläche (5), wobei die Platte ein elektromechanisches Material aufweist und an deren Grundfläche und an deren der Grundfläche gegenüberliegenden Deckfläche Elektroden (6, 6', 7, 7') zur Anregung periodischer Deformationen der Platte angeordnet sind, und die Grundfläche (3) wenigstens zwei parallel zueinander angeordnete Seiten (8, 8') aufweist, welche Kontaktabschnitte (50, 50') der Seitenfläche (5) bilden, und die zwei parallel zueinander angeordneten Seiten der Grundfläche zusammen mit Verbindungslinien (9, 9'), welche die jeweiligen Endpunkte der parallel zueinander angeordneten Seiten (8, 8') miteinander verbinden, ein in die Grundfläche einbeschriebenes Parallelogramm (10) bilden, **dadurch gekennzeichnet, dass** bei dem eingeschriebenen Parallelogramm (10) zwischen aneinanderstoßenden Seiten ein von 90° abweichender Winkel eingeschlossen ist, wobei die Grundfläche (3) achteckig ist und sich beidseits des eingeschriebenen Parallelogramms (10) jeweils ein Trapez (12, 12') anschließt, und die Basis (13, 13') jedes Trapezes (12, 12') mit der jeweiligen längeren Seite des eingeschriebenen Parallelogramms (10) zusammenfällt.

2. Ultraschallaktuator nach Anspruch 1, **dadurch gekennzeichnet, dass** die größeren Innenwinkel (11) des eingeschriebenen Parallelogramms einen Wert zwischen 93° und 105° und bevorzugt zwischen 95° und 99° aufweisen.

3. Ultraschallaktuator nach Anspruch 1, **dadurch gekennzeichnet, dass** jedes Trapez (12, 12') ein gleichschenkliges Trapez ist.

4. Ultraschallaktuator nach Anspruch 3, **dadurch gekennzeichnet, dass** die Länge jeder Diagonale (14) eines Trapezes (12, 12') im Wesentlichen identisch ist zu dem Abstand (15) zwischen der der Basis (13, 13') dieses Trapezes gegenüberliegenden Seite (16, 16') und der Basis (13, 13') des jeweils anderen Trapezes (12, 12').

5. Motor (100) mit einem Ultraschallaktuator (1) nach einem der vorhergehenden Ansprüche, umfassend eine Halterungsvorrichtung (110) zur ortsfesten Halterung des Ultraschallaktuators und einen relativ zu dem Ultraschallaktuator beweglichen und sich mit diesem in Friktionskontakt befindenden Läufer (120).

6. Motor (100) nach Anspruch 5, **dadurch gekennzeichnet, dass** die Halterungsvorrichtung (110) wenigstens vier Halteabschnitte (111, 11 V , 112, 112', 113, 113') aufweist, die den Ultraschallaktuator an unterschiedlichen Abschnitten (52, 52', 54, 54') der Seitenfläche (5) kontaktieren, wovon zwei Halteabschnitte mechanisch steif ausgeführt ist steife Halteabschnitte (111 , 11 V) bilden, und wovon zwei Halteabschnitte federnde Eigenschaften aufweisen und federnde Kontaktabschnitte (112, 112') bilden.

7. Motor nach Anspruch 6, **dadurch gekennzeichnet, dass** die steifen Halteabschnitte (111, 111') und die federnden Halteabschnitte (112, 112') jeweils schräg gegenüberliegend zueinander angeordnet sind.

8. Motor nach Anspruch 6 oder 7, **dadurch gekennzeichnet, dass** die Halterungsvorrichtung (110) zwei weitere Halteabschnitte (113, 113') aufweist, die jeweils einen Abschnitt (56, 56') der Seitenfläche (5) des Ultraschallaktuators kontaktieren, der zwischen dem von dem jeweiligen steifen Halteabschnitt (111, 111') und dem jeweiligen federnden Halteabschnitt (112, 112') kontaktierten Bereich der Seitenfläche (5) gelegen ist.

9. Motor nach einem der Ansprüche 5 bis 8, **dadurch gekennzeichnet, dass** der Läufer (120) zwei langgestreckte und parallel zueinander angeordnete Laufflächen (122, 122') umfasst, die den Ultraschallaktuator (1) an dessen Kontaktabschnitten (50, 50') direkt oder indirekt kontaktieren und den Ultraschallaktuator derart zwischen sich einspannen, dass ein Drehmoment auf den Ultraschallaktuator wirkt, durch welches jeweils derjenige Abschnitt (52, 52', 54, 54') der Seitenfläche (5), der mit dem steifen Kontaktabschnitt in Kontakt steht, gegen diesen gedrückt ist.

10. Motor nach einem der Ansprüche 5 bis 9, **dadurch gekennzeichnet, dass** der Läufer (120) wenigstens zwei voneinander beabstandete Führungsabschnitte (125, 125') umfasst, die sich mit separat vorliegenden Führungselementen (130, 130') oder mit Führungsabschnitten (116, 116') der Halterungsvorrichtung (110) in einem Kontakt befinden, der eine gleitende Relativbewegung zwischen den Führungsabschnitten (125, 125') und den Führungselementen (130, 130') oder den Führungsabschnitten (116, 116') erlaubt.

## Claims

1. Ultrasonic actuator (1) in the form of a plate (2) having a base (3), a cover surface (4) geometrically similar to the base, and a side surface (5) interconnecting the base and the cover surface, wherein the plate includes an electromechanical material and electrodes (6, 6', 7, 7') are arranged on its base and on its cover surface opposite the base for exciting periodic deformations of the plate, and the base (3) includes at least two sides (8, 8') that are arranged parallel to one another and form contact portions (50, 50') of the side surface (5), and the two sides of the base that are arranged parallel to one another, together with connecting lines (9, 9') that mutually connect the respective end points of the sides (8, 8') arranged parallel to one another, form a parallelogram (10) inscribed in the base, **characterized in that**, in the inscribed parallelogram (10) an angle other than 90° is defined between abutting sides, wherein the base (3) is octagonal and a trapezoid (12, 12') adjoins each side of the inscribed parallelogram (10), and the base (13, 13') of each trapezoid (12, 12') coincides with the respective longer side of the inscribed parallelogram (10)..

2. Ultrasonic actuator according to claim 1, **characterized in that** the larger interior angles (11) of the inscribed parallelogram have a value between 93° and 105° and preferably between 95° and 99°.

3. Ultrasonic actuator according to claim 1, **characterized in that** each trapezoid (12, 12') is an isosceles trapezoid.

4. Ultrasonic actuator according to claim 3, **characterized in that** the length of each diagonal (14) of a trapezoid (12, 12') is substantially identical to the distance (15) between the side (16, 16') opposite the base (13, 13') of this trapezoid and the base (13, 13') of the respective other trapezoid (12, 12').

5. Motor (100) comprising an ultrasonic actuator (1) according to any one of the preceding claims, comprising a mounting device (110) for fixedly retaining the ultrasonic actuator and an armature (120) movable relative to and in frictional contact with the ultrasonic actuator.

6. Motor (100) according to claim 5, **characterized in that** the mounting device (110) comprises at least four retaining portions (111, 111', 112, 112', 113, 113') contacting the ultrasonic actuator at different portions (52, 52', 54, 54') of the side surface (5), of which two retaining portions are mechanically rigid and form rigid retaining portions (111, 111'), and of which two retaining portions have resilient properties and form resilient contact portions (112, 112').

7. Motor according to claim 6, **characterized in that** the rigid retaining portions (111, 111') and the resilient retaining portions (112, 112') are each arranged obliquely opposite to one another.

8. Motor according to claim 6 or 7, **characterized in that** the mounting device (110) comprises two further retaining portions (113, 113') each contacting a portion (56, 56') of the side surface (5) of the ultrasonic actuator located between the area of the side surface (5) contacted by the respective rigid retaining portion (111, 111 ') and the respective resilient retaining portion (112, 112').

9. Motor according to any one of claims 5 to 8, **characterized in that** the armature (120) comprises two elongated and mutually parallel running surfaces (122, 122') which contact the ultrasonic actuator (1) directly or indirectly at its contact portions (50, 50') and clamp the ultrasonic actuator between them in such a way that a torque acts on the ultrasonic actuator, by means of which in each case that portion (52, 52', 54, 54') of the side surface (5) that is in contact with the rigid contact portion is pressed against the latter.

10. Motor according to any one of claims 5 to 9, **characterized in that** the armature (120) comprises at least two guide portions (125, 125') spaced apart from one another, which are in a contact with separately provided guide elements (130, 130') or with guide portions (116, 116') of the mounting device (110) so as to enable a sliding relative movement between the guide portions (125, 125') and the guide elements (130, 130') or the guide portions (116, 116').

## Revendications

1. Actionneur à ultrasons (1) ayant la forme d'une plaque (2) avec une surface de base (3), une surface supérieure (4) géométriquement similaire à la surface de base, et une surface latérale (5) connectant entre elles la surface de base et la surface supérieure, dans lequel la plaque comporte un matériau électromécanique et des électrodes (6, 6', 7, 7') destinées à provoquer des déformations périodiques de la plaque, qui sont agencées sur la surface de base et sur la surface supérieure opposée à la surface de base, et la surface de base (3) présente au moins deux côtés (8, 8') agencés parallèlement entre eux qui forment des sections de contact (50, 50') de la surface latérale (5), et les deux côtés de la surface de base agencés parallèlement entre eux conjointement à des lignes de connexion (9, 9'), qui connectent entre elles les extrémités respectives des côtés (8, 8') agencés parallèlement entre eux, forment un parallélogramme (10) inscrit dans la surface de base, **caractérisé en ce que** dans le parallélogramme inscrit (10), un angle différent de 90° est formé par les côtés contigus, dans lequel la surface de base (3) est octogonale et comporte un trapèze (12, 12') adjoint de part et d'autre du parallélogramme inscrit (10), et la base (13, 13') de chaque trapèze (12, 12') coïncide avec le côté le plus long respectif du parallélogramme inscrit (10).

2. Actionneur à ultrasons selon la revendication 1, **caractérisé en ce que** les plus grands angles internes (11) du parallélogramme inscrit ont une valeur comprise entre 93° et 105°, et de préférence entre 95° et 99°.

3. Actionneur à ultrasons selon la revendication 1, **caractérisé en ce que** chaque trapèze (12, 12') est un trapèze isocèle.

4. Actionneur à ultrasons selon la revendication 3, **caractérisé en ce que** la longueur de chaque diagonale (14) d'un trapèze (12, 12') est sensiblement identique à la distance (15) entre le côté (16, 16') opposé à la base (13, 13') de ce trapèze et la base (13, 13') de l'autre trapèze (12, 12') respectif.

5. Moteur (100) avec un actionneur à ultrasons (1) selon l'une des revendications précédentes, comprenant un dispositif de support (110) pour supporter de manière fixe l'actionneur à ultrasons, et un rotor (120) qui est mobile par rapport à l'actionneur à ultrasons et est en contact par friction avec celui-ci.

6. Moteur (100) selon la revendication 5, **caractérisé en ce que** le dispositif de support (110) comporte au moins quatre sections de support (111, 111', 112, 112', 113, 113') qui maintiennent le contact avec l'actionneur à ultrasons dans les différentes sections (52, 52', 54, 54') de la surface latérale (5), dont deux sections de support sont conçues pour être mécaniquement rigides afin de former des sections de support rigides (111, 111'), et dont deux sections de support présentent des propriétés élastiques et forment des sections de contact élastiques (112, 112').

7. Moteur selon la revendication 6, **caractérisé en ce que** les sections de support rigides (111, 111') et les sections de support élastiques (112, 112') sont agencées chacune obliquement l'une en face de l'autre.

8. Moteur selon la revendication 6 ou 7, **caractérisé en ce que** le dispositif de support (110) présente deux autres sections de support (113, 113'), qui sont chacune en contact avec une section (56, 56') de la surface latérale (5) de l'actionneur à ultrasons située entre les zones de la surface latérale (5) contactées par la section de support rigide (111, 111') et la section de support élastique (112, 112') correspondantes.

9. Moteur selon l'une des revendications 5 à 8, **caractérisé en ce que** le rotor (120) comprend deux surfaces de palier (122, 122') allongées et parallèles l'une à l'autre, qui entrent directement ou indirectement en contact avec l'actionneur à ultrasons (1) sur ses sections de contact (50, 50') et qui serrent l'actionneur à ultrasons entre elles de telle sorte qu'un couple agisse sur l'actionneur à ultrasons, moyennant lequel la section correspondante (52, 52', 54, 54') de la surface latérale (5) qui est en contact avec la section de contact rigide est poussée contre celle-ci.

10. Moteur selon l'une des revendications 5 à 9, **caractérisé en ce que** le rotor (120) comprend au moins deux sections de guidage (125, 125') espacées qui sont en contact avec des éléments de guidage (130, 130') séparés ou avec des sections de guidage (116, 116') du dispositif de support (110), ce qui permet un déplacement relatif coulissant entre les sections de guidage (125, 125') et les éléments de guidage (130, 130') ou les sections de guidage (116, 116').
